# EUROPÄISCHE PATENTSCHRIFT

(11) **EP 0 543 045 B1**
(45) Veröffentlichungstag und Bekanntmachung des Hinweises auf die Patenterteilung: **20.09.1995**
(21) Anmeldenummer: 91119852.1
(22) Anmeldetag: 21.11.1991
(51) Int. Cl.: H05K 3/02, H05K 3/10

(54) **Verfahren zur Herstellung von Leiterplatten**
Process for manufacturing printed circuit boards
Procédé de fabrication de plaques à circuit imprimé

(43) Veröffentlichungstag der Anmeldung: 26.05.1993
(73) Patentinhaber: SIEMENS AKTIENGESELLSCHAFT, 80333 München (DE)
(72) Erfinder: Schumacher, Hartmut, Dipl.-Ing. (FH), W-8451 Ebermannsdorf (DE)

(56) Entgegenhaltungen:
- EP-A- 0 287 843
- EP-A- 0 361 192
- DE-C- 3 843 230
- US-A- 4 898 648
- IBM TECHNICAL DISCLOSURE BULLETIN, Bd. 32, Nr. 6B, November 1989, New York,US;Seiten 359 - 361; "Laser scribed labyrinth type circuit for circuit board"

## Beschreibung

Aus der EP-A-0 062 300 ist ein Verfahren zur Herstellung von Leiterplatten bekannt, bei welchem eine ganzflächig auf eine Metallschicht aufgebrachte metallische Ätzresistschicht mittels eines Laserstrahls selektriv wieder entfernt wird und das Leiterbild durch Abätzen der derart freigelegten Metallschicht strukturiert werden kann. Um bei diesem bekannten Verfahren die Metallschicht zwischen den Leiterbahnen durch Ätzen vollständig entfernen zu können, muß zuvor die darüberliegende Ätzresistschicht ebenfalls vollständig entfernt werden. Diese Entfernung der Ätzresistschicht, die mit einem Laserstrahl vorgenommen wird, ist jedoch aufwendig und zeitraubend. Dies trifft insbesondere dann zu, wenn die Leiterbahnen relativ weit auseinander liegen und die Flächen der mit dem Laser abzutragenden Ätzresistschicht somit relativ groß sind.

Bei einem aus der US-A-4 943 346 bekannten Verfahren zur Herstellung von Leiterplatten werden im Unterschied zu dem vorstehend beschriebenen Verfahren nur die unmittelbar an das spätere Leiterbild angrenzenden Bereiche der Ätzresistschicht mittels elektromagnetischer Strahlung, vorzugsweise Laserstrahlung, entfernt. Die Konturbeschreibung mittels der elektromagnetischen Strahlung ist also als eine enge Umfahrung oder Umschreibung des Leiterbildes anzusehen, die im Hinblick auf die geringe Flächenausdehnung der abzutragenden Ätzresistschicht rasch vorgenommen werden kann. Die nicht dem Leiterbild entsprechenden Bereiche werden anodisch kontaktiert, worauf hier die Ätzresistschicht elektrolytisch abgetragen und die dadurch freigelegte Metallschicht weggeätzt werden kann.

Der im Anspruch 1 angegebenen Erfindung liegt das Problem zugrunde, das aus der US-A-4 943 346 bekannte Verfahren weiter zu vereinfachen.

Dieses Problem wird gelöst durch ein Verfahren mit den merkmalen des Anspruchs 1.

Die mit der Erfindung erzielten Vorteile bestehen insbesondere darin, daß mit sehr wenigen Verfahrensschritten ausgekommen werden kann. Es entfallen das Aufbringen von Resistschichten und Ätzverfahren. Für die kathodische Kontaktierung der dem Leiterbild entsprechenden Bereiche müssen diese Bereiche elektrisch leitend miteinander verbunden werden, was jedoch durch eine entsprechende Gestaltung der Leiterbahnmuster und/oder durch Klemmen, Kontaktbrücken oder dergleichen problemlos erreicht werden kann. Gegebenenfalls können auch zur kathodischen Kontaktierung benutzte Verbindungsstege später wieder durchgetrennt werden.

Vorteilhafte Ausgestaltungen der Erfindung sind in den Ansprüchen 2 bis 12 angegeben. Ein Ausführungsbeispiel der Erfindung ist in der Zeichnung dargestellt und wird im folgenden näher beschrieben.

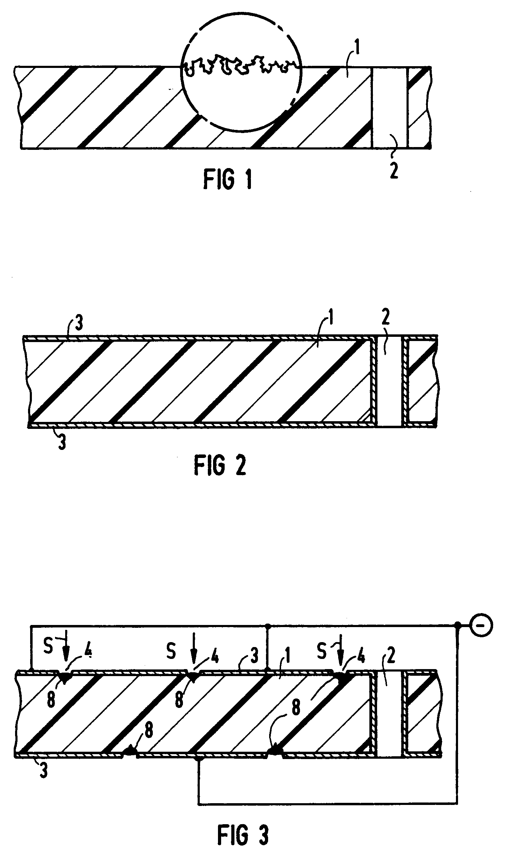

Die Figuren 1 bis 6 zeigen in stark vereinfachter schematischer Darstellung die verschiedenen Verfahrensstadien bei der Herstellung von Leiterplatten nach der Erfindung.

Bei dem in FIG 1 dargestellten Substrat 1 handelt es sich um einen Ausschnitt eines dreidimensionalen, d.h. schachtelförmigen oder abgewinkelten Basismaterials mit eingespritzten Durchkontaktierungslöchern 2. Als Materialien für die Substrate derartiger Leiterplatten sind insbesondere hochtemperaturbeständige Thermoplaste geeignet.

Das in FIG 1 dargestellte Substrat 1 wurde zunächst zur Erhöhung der Haftfestigkeit der später aufzubringenden Leiterbahnen und Durchkontaktierungen vorbehandelt. Dies kann mechanisch oder chemisch durch Beizen und anschließendes Reinigen erfolgen. Dabei werden sowohl für das Beizen als auch für die Reinigung des Substrats 1 handelsübliche Bäder verwendet.

Nach der mechanischen bzw. chemischen Vorbehandlung erfolgt die Bekeimung des Substrats 1. Die in der Zeichnung in vergrößertem Maßstab in FIG 1 angedeutete Bekeimung wurde als dünne Schicht auf die Oberfläche des Substrats 1 und auf die Wandungen der Durchkontaktierungslöcher 2 aufgebracht. Das Aufbringen der Bekeimung erfolgt dabei durch Eintauchen des Substrats 1 in ein Pd Cl₂ - Sn Cl₂ - Bad. Für das Aufbringen der Bekeimung haben sich aber auch handelsübliche Bäder auf der Basis palladiumorganischer Verbindungen als geeignet erwiesen.

Nach dem Aufbringen der Bekeimung wurde dieses aktiviert, wobei es sich hier um ein in der Additivtechnik übliches Reduzieren bzw. Beschleunigen handelt.

Anschließend wurde gemäß FIG 2 durch außenstromlose chemische Metallabscheidung eine beispielsweise 0,5 bis 2 Mikrometer starke erste Metallschicht 3 aufgebracht. Es ist ersichtlich, daß diese erste Metallschicht 3, die im geschilderten Ausführungsbeispiel in einem handelsüblichen stromlosen Kupferbad aufgebracht wurde, die Oberfläche des Substrats 1 und die Wandungen der Durchkontaktierungslöcher 2 überzieht.

Gemäß FIG 3 wird die Kupferschicht mit Hilfe eines Nd-YAG-Lasers in einem Scannverfahren strukturiert, wobei die Strahlung durch Pfeile S lediglich angedeutet ist. Es ist zu erkennen, daß die Entfernung der dünnen Kupferschicht an den an das spätere Leiterbild angrenzenden Bereichen 4 erfolgt. Die Einstellung und Führung bzw. die Intensität des Lasers wird so eingestellt, daß das Kupfer in diesen Bereichen vollständig verbrannt bzw. weggeschmolzen wird. Der Laser bleibt sozusagen in dem Kunststoff der Leiterplatten stecken, seine Restenergie wird dort aufgebraucht. Mit der Restenergie wird auch die Palladiumbekeimung ausreichend zerstört und eine genügende galvanische Trennung zwischen den einzelnen Leiterbahnen gewährleistet ist, da keine erneute Anlagerung leitender Teile an den Palladiumkeimen erfolgen kann. Nach dem Laservorgang werden die dem Leiterbild entsprechenden Bereiche der ersten Metallschicht 3 kathodisch kontaktiert. Diese kathodische Kontaktierung, die beispielsweise durch Klemmen, Kontaktbrücken oder dgl. hergestellt wird, ist auch in FIG 3 schematisch dargestellt, es können jedoch im Layout bereits Leiterbahnenverbindungen vorgesehen werden (Galvanorahmen), die danach mechanisch entfernt werden. Dies kann durch mechanisches Trennen von außenliegenden Brücken erfolgen.

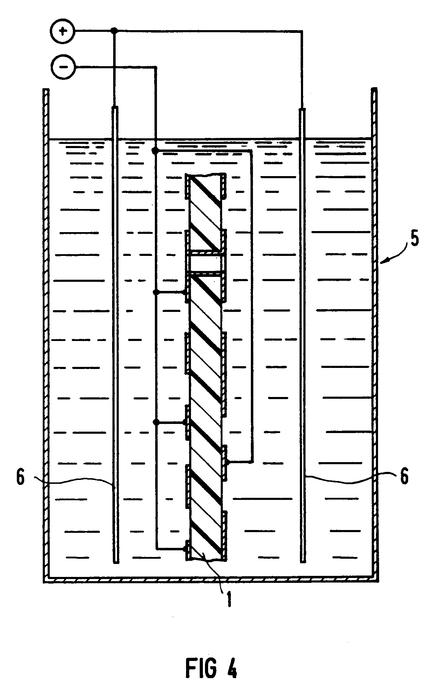

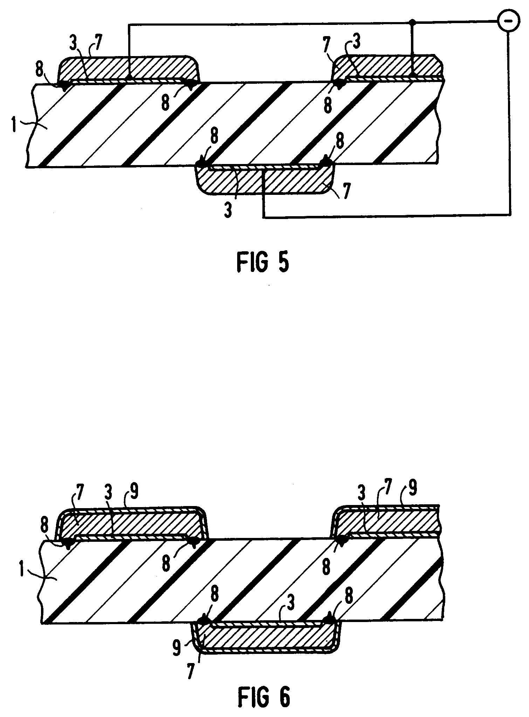

Gemäß FIG 4 wird die gesamte Leiterplatte, deren kathodische Kontaktierung durch ein Minuszeichen angedeutet ist, dann in ein galvanisches Metallabscheidungsbad 5 eingebracht. In diesem rein schematisch dargestellten galvanischen Metallabscheidungsbad 5 sind die mit dem Pluspol einer Stromquelle verbundenen Anoden 6 zu beiden Seiten der Leiterplatte angeordnet, der Pulspol ist durch ein Pluszeichen angedeutet, in dem Metallabscheidungsbad 5 befindet sich im geschilderten Ausführungsbeispiel ein handelsübliches galvanisches Kupferbad. Derartige galvanische Kupferbäder werden beim additiven Aufbau von Leiterbahnen verwendet. Hierdurch wurde durch das Bad die nicht elektrisch kontaktierten metallisierten Bereiche wieder freigelegt (FIG 5).

Gemäß FIG 5 wurde in dem vorstehend erwähnten galvanischen Metallabscheidungsbad 5 auf die kathodisch kontaktierten Bereiche der ersten Metallschicht 3, d.h. auf die dem Leiterbild entsprechenden Bereich der ersten Metallschicht 3 eine zweite Metallschicht 7 aufgebracht, die die entsprechende Stärke für die notwendige Stromleitung der Leiterbahnen aufweist. Hierdurch werden auch die Spuren 8 der Laserbehandlung abgedeckt.

Gemäß FIG 6 kann auf die zweite Metallschicht 7 gegebenenfalls noch eine lötbare Oberfläche 9 aufgebracht werden, die im geschilderten Ausführungsbeispiel aus einer Zinn-Blei-Legierung bestehen kann. Das Aufbringen der lötbaren Oberfläche 9 erfolgt in einem galvanischen Zinn-Blei-Abscheidungsbad wobei hierbei die aus den Figuren 4 und 5 erkennbare kathodische Kontaktierung ausgenutzt werden kann.

## Patentansprüche

1. Verfahren zur Herstellung von Leiterplatten mit folgenden aufeinander folgenden Verfahrensschritten:
a) die Leiterplatte (1) wird zur Haftung einer Metallauflage (3) vorbehandelt;
b) eine dünne erste Metallschicht (3) wird aufgetragen;
c) die Metallschicht (3) wird nur in den unmittelbar an das spätere Leiterbild angrenzenden Bereichen mittels eines Spurenzeichnenden Lasers durch elektromagnetische Strahlung (S) entfernt und zwar durch derartige Einstellung und Führung der Strahlung (S), daß sich eine Trennung der Bahnen und eine Unschädlichmachung der Vorbehandlungsfolgen in der Leiterplatte ergibt;
d) die dem Leiterbild entsprechenden Bereiche der Metallschicht (3) werden kathodisch kontaktiert;
e) auf die kathodisch kontaktierten Bereiche wird in einem galvanischen Metallabscheidungsbad eine zweite Metallschicht (7) aufgebracht, wodurch
f) die nicht elektrisch kontaktierten Bereiche durch das galvanische Abscheidungsbad wieder freigelegt werden, und
g) die durch den Laser gezeichneten Spuren durch die zweite Metallschicht (7) vollständig abgedeckt werden.

2. Verfahren nach Anspruch 1, **dadurch gekennzeichnet**, daß die erste Metallschicht (3) durch stromlose Metallabscheidung auf das Substrat (1) aufgebracht wird.

3. Verfahren nach Anspruch 1, **dadurch gekennzeichnet**, daß die erste Metallschicht (3) durch stromlose Abscheidung von Kupfer auf das Substrat (1) aufgebracht wird.

4. Verfahren nach Anspruch 1, 2 oder 3, **dadurch gekennzeichnet**, daß die erste Metallschicht in einer Stärke von 0,5 bis 2 Mikrometer auf das Substrat aufgebracht wird.

5. Verfahren nach Anspruch 4, **dadurch gekennzeichnet**, daß die elektromagnetische Strahlung (S) durch einen Nd-YAG-Laser erzeugt wird.

6. Verfahren nach Anspruch 4 oder 5, **dadurch gekennzeichnet**, daß die Bewegung des Laserstrahls relativ zum Substrat (1) frei programmierbar ist.

7. Verfahren nach Anspruch 4, 5 oder 6, **dadurch gekennzeichnet**, daß die im Schritt c) vorgenommene Entfernung der Metallschicht durch mehrfache Umfahrung des späteren Leiterbildes mit einem Laserstrahl bewirkt wird.

8. Verfahren nach Anspruch 7, **dadurch gekennzeichnet**, daß auf die zweite Metallschicht (7) eine lötbare Oberfläche (9) aus einer Zinn-Blei-Legierung aufgebracht wird.

9. Verfahren nach Anspruch 8, **dadurch gekennzeichnet**, daß die lötbare Oberfläche (9) durch galvanische Metallabscheidung aufgebracht wird.

10. Verfahren nach einem der vorhergehenden Ansprüche, **dadurch gekennzeichnet**, daß ein dreidimensionales, spritzgegossenes Substrat (1) verwendet wird.

11. Verfahren nach Anspruch 10, **dadurch gekennzeichnet**, daß ein Substrat (1) mit eingespritzten Durchkontaktierungslöchern (2) verwendet wird.

## Claims

1. Method for producing printed circuit boards with the following successive method steps:
a) the printed circuit board (1) is pretreated for the adhesion of a metal coating (3);
b) a thin first metal layer (3) is applied thereto:
c) the metal layer (3) is removed just in the areas directly adjacent to the future conductive pattern by means of a track-drawing laser by electromagnetic radiation (S), that is, by such adjustment and guidance of the radiation (S) that the paths are separated and the consequences of pretreatment in the printed circuit board are rendered harmless;
d) the areas of the metal layer (3) which correspond to the conductive pattern are contacted cathodically;
e) a second metal layer (7) is applied to the cathodically contacted areas in an electrodeposition bath, whereby
f) the areas which are not electrically contacted are exposed again by means of the electrodeposition bath, and
g) the tracks drawn by means of the laser are completely covered by the second metal layer (7).

2. Method according to claim 1, characterised in that the first metal layer (3) is applied to the substrate (1) by means of currentless metal deposition.

3. Method according to claim 1, characterised in that the first metal layer (3) is applied to the substrate (1) by means of currentless deposition of copper.

4. Method according to claim 1, 2 or 3, characterised in that the first metal layer is applied to the substrate to a thickness of 0.5 to 2 micrometers.

5. Method according to claim 4, characterised in that the electromagnetic radiation (S) is generated by means of an Nd-YAG-laser.

6. Method according to claim 4 or 5, characterised in that the movement of the laser beam relative to the substrate (1) is freely programmable.

7. Method according to claim 4, 5 or 6, characterised in that the removal of the metal layer carried out in step c) is effected by moving a laser beam repeatedly around the future conductive pattern.

8. Method according to claim 7, characterised in that a solderable surface (9) consisting of a tin-lead-alloy is applied to the second metal layer (7).

9. Method according to claim 8, characterised in that the solderable surface (9) is applied by means of electrodeposition.

10. Method according to one of the preceding claims, characterised in that a three-dimensional, injection-moulded substrate (1) is used.

11. Method according to claim 10, characterised in that a substrate (1) is used that has plated-through holes (2) injected therein.

## Revendications

1. Procédé pour fabriquer des plaquettes à circuits imprimés, comprenant les étapes opératoires successives suivantes :
a) on applique un traitement préalable à la plaquette à circuits imprimés (1) pour y faire adhérer un revêtement métallique (3);
b) on dépose une première couche métallique mince (3);
c) on retire la couche métallique (3) uniquement dans les zones qui sont directement contiguës à la configuration de conducteurs formée ultérieurement, au moyen d'un laser dessinant une trace, à l'aide d'un rayonnement électromagnétique (S), et ce au moyen d'un réglage et d'un guidage tels du rayonnement (S) qu'on obtient une séparation des voies et une neutrolisation des conséquences néfastes qui pourraient résulter du traitement préalable dans la plaquette à circuits imprimés;
d) on réalise par voie cathodique des plots du contact dans les régions, qui correspondent à la configuration de conducteurs, de la couche métallique (3);
e) sur les régions dans lesquels sont réalisés les contacts cathodique, on dépose une seconde couche métallique (7) dans un bain de dépôt galvanique d'un métal, ce qui a pour effet que
f) les régions sur lesquelles n'ont pas été réalisés des contacts électriques, sont à nouveau mises à nu par le bain de dépôt galvanique, et
g) les pistes tracées au moyen du laser sont complètement recouvertes par la seconde couche métallique (7).

2. Procédé suivant la revendication 1, caractérisé par le fait qu'on dépose la première couche métallique (3) au moyen d'un dépôt métallique sans courant sur le substrat (1).

3. Procédé suivant la revendication 1, caractérisé par le fait qu'on dépose la première couche métallique (3) au moyen d'un dépôt autocatalytique de cuivre sur le substrat (1).

4. Procédé suivant la revendication 1, 2 ou 3, caractérisé en ce qu'on dépose la première couche métallique avec une épaisseur de 0,5 à 2 microns sur le substrat.

5. Procédé suivant la revendication 4, caractérisé par le fait que le rayonnement électromagnétique (S) est produit par un laser Nd-YAG.

6. Procédé suivant la revendication 4 ou 5, caractérisé par le fait que le déplacement du faisceau laser par rapport au substrat (1) est librement programmable.

7. Procédé suivant la revendication 4, 5 ou 6, caractérisé par le fait que l'élimination, prévue lors de l'étape (c), de la couche métallique est obtenue au moyen d'un passage multiple d'un faisceau laser autour de la configuration des conducteurs formée ultérieurement.

8. Procédé suivant la revendication 7, caractérisé par le fait qu'on dépose une surface apte à être brasée (9) formée d'un alliage étain-plomb sur la seconde couche métallique (7).

9. Procédé suivant la revendication 8, caractérisé par le fait qu'on dépose la surface apte à être brasée (9) au moyen d'un dépôt galvanique d'un métal.

10. Procédé suivant l'une des revendications précédentes, caractérisé par le fait qu'on utilise un substrat tridimensionnel (1) moulé par injection.

11. Procédé suivant la revendication 10, caractérisé par le fait qu'on utilise un substrat (1) comportant des trous de contact traversants (2) formés par moulage par injection.
